(19) Europäisches Patentamt

European Patent Office

Office européen des brevets

(11) **EP 1 263 112 A2**

(12) **EUROPEAN PATENT APPLICATION**

(43) Date of publication:
**04.12.2002 Bulletin 2002/49**

(51) Int Cl.7: **H02J 7/00**, G01R 19/00

(21) Application number: **02252276.7**

(22) Date of filing: **27.03.2002**

(84) Designated Contracting States:
**AT BE CH CY DE DK ES FI FR GB GR IE IT LI LU
MC NL PT SE TR**
Designated Extension States:
**AL LT LV MK RO SI**

(30) Priority: **31.05.2001 GB 0113306**

(71) Applicant: **Matsushita Communication Industrial
UK Ltd.
Thatcham, Berks RG19 4ZD (GB)**

(72) Inventor: **Harley, John Andrew
Basingstoke, Hampshire RG24 8RF (GB)**

(74) Representative: **Dawson, Elizabeth Ann et al
A.A. Thornton & Co.
235 High Holborn
London WC1V 7LE (GB)**

(54) **Charging circuits for portable communication terminals**

(57)     Current sensing during recharging of a battery in a portable communication terminal is achieved without the use of a dedicated sense resistor. The type of charger attached to the terminal is established from the measured difference in potential between battery and charger. The accuracy of the computation of current in the charging circuit relies on estimated values of impedance and voltage drops across in-circuit components. Estimated values may vary in accordance with the current temperature of the components for which the estimates are derived.

Figure 2

**Description**

This invention relates to charging circuits for portable communication terminals and in particular it relates to current sensing.

Portable communication terminals depend upon rechargeable batteries for their power supply. These batteries need to be charged periodically to maintain the availability of the power supply to the terminal. Problems can occur when attempting to recharge batteries and some form of charging control is therefore implemented. In order to achieve proper control of charging, measurements of battery voltage and battery temperature and changes of these quantities with time are required.

A measure of the level of charging current is also required. Various types of chargers may be used when recharging the batteries of portable communications terminals. A fast charger may be used in a vehicle to provide a charging rate of say 700 milliamps and would charge a battery fully in about an hour. A less expensive slow charger charging at a rate of 400 milliamps for almost two hours is usually preferred in a domestic environment.

In order to avoid dangerous overcharging of the battery a safety timer can be set to terminate charging after an appropriate charging interval. The duration of the safety timer would be set in accordance with the maximum charging time for the charger being used. In this instance a measurement of charging current must be sufficiently accurate at least to discriminate between fast and slow chargers so that the correct safety timer can be set. A more accurate measurement will be needed when a specific variation in the amount of the charging current during the charging cycle is required.

The standard prior art method of measuring the level of current passing through a charging circuit is by means of a voltage measurement across an in-circuit resistance of known value. The low resistance, high power dissipation resistors used for this purpose cause complications in the design process. These complications arise from local heating from the power dissipated in the resistor, the relatively large volume of such resistors and the cost of the resistor(s). Charging arrangements for mobile phones and the use of sensing resistors are discussed in e.g. US 5 764 035 to Lee and US 6 040 683 to Mottier.

It is an object of the invention to dispense with a dedicated sense resistor in charging circuits of portable communication terminals and to obtain current sensing measurements using characteristics of other components necessarily included in the charging circuit.

According to the invention there is provided a portable communications terminal including a battery and having a charging circuit for connecting an external charger to said battery, said charging circuit comprising a pass device and a diode connected in series and in which levels of charging current are computed from a difference of potential between said external charger and said battery and stored characteristics of said pass device and diode.

An example of the invention will now be described in more detail with reference to the accompanying figures in which:

figure 1 is a block diagram showing parts of a mobile phone,

figure 2 a circuit diagram of a charging circuit,

figure 3 is a plot of FET on-resistance versus drain current,

figure 4 is a plot of diode forward current versus forward voltage.

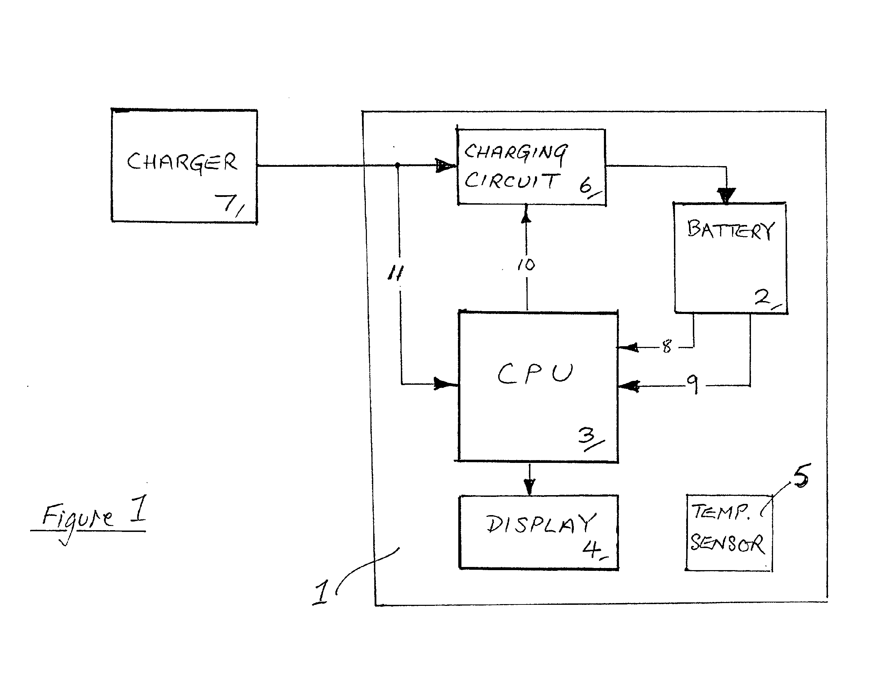

In this example the portable electronic terminal is a mobile phone shown generally at **1** in figure 1. The mobile phone is provided with the usual functional features such as a keypad for a user interface, transmitting and receiving sections for wireless connection with the network, microphone, loudspeaker and memory. The main power supply for the phone is derived from a nickel metal hydride battery of capacity 700 milliamp hours and voltage 3.6 volts (numeral 2 figure 1). The charging unit (numeral **7** figure 1) is one of a standard type, generally available, supplying a constant current and having an off-load voltage of 5.8 volts.

With reference to figure 1, a mobile phone **1** operates under the control of a central processing unit (CPU) **3**. A battery **2** supplies power to the phone. Included in the battery pack adjacent the battery is a temperature sensor such as a thermistor (not shown). Battery terminal voltage, a voltage representative of temperature level and charger terminal voltage are available at CPU **3** via connections **8** and **9** and **11.** A liquid crystal display (LCD) **4** indicates the state of charge of the battery **2.**

When charging of the battery is required, a charging unit **7** is connected to the phone for the duration of the charging cycle. The charging process is controlled by CPU **3**. A charging circuit **6,** comprising a pass device and a diode connected in series, connects the charger **7** to the battery **2**. The pass device in this example is a field effect transistor (FET). A temperature sensor **5** is attached to the main printed circuit board in the region of the charging circuit.

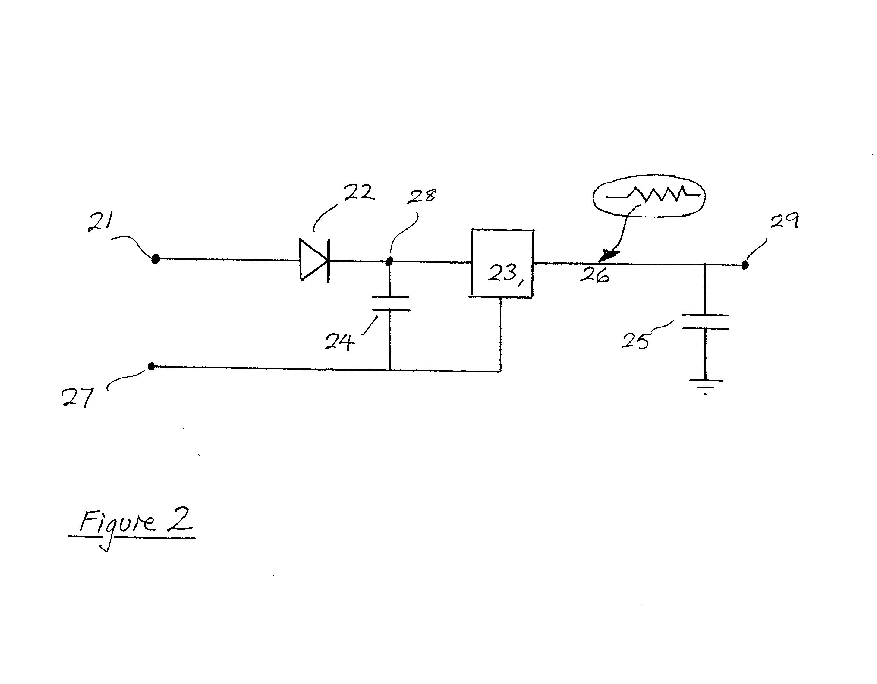

With reference to figure 2 a charging circuit is shown in more detail. The output from the charging unit **7** is applied to terminal **21**. The circuit components comprise a diode **22,** a pass device FET **23,** stabilising capacitor **24** and reservoir capacitor **25**. Diode **22** is connected to the source of FET **23** and the drain of FET **23** is connected to the battery **2.** In prior art circuits a current sensing resistor would be included in the circuit at **26** for example. The primary purpose of the diode **22** is to protect against the effect of a short circuit occurring in the charger during charging.

Terminal **27** is connected to the gate of FET **23**. The level of current passing through FET **23** depends upon the current applied to terminal **27**. The amount of current applied to terminal **27** is controlled by CPU **3**. In this example the pass device FET **23** acts as a switch such that it is fully on when current is applied to terminal **27** otherwise it is off and does not pass current from source to drain.

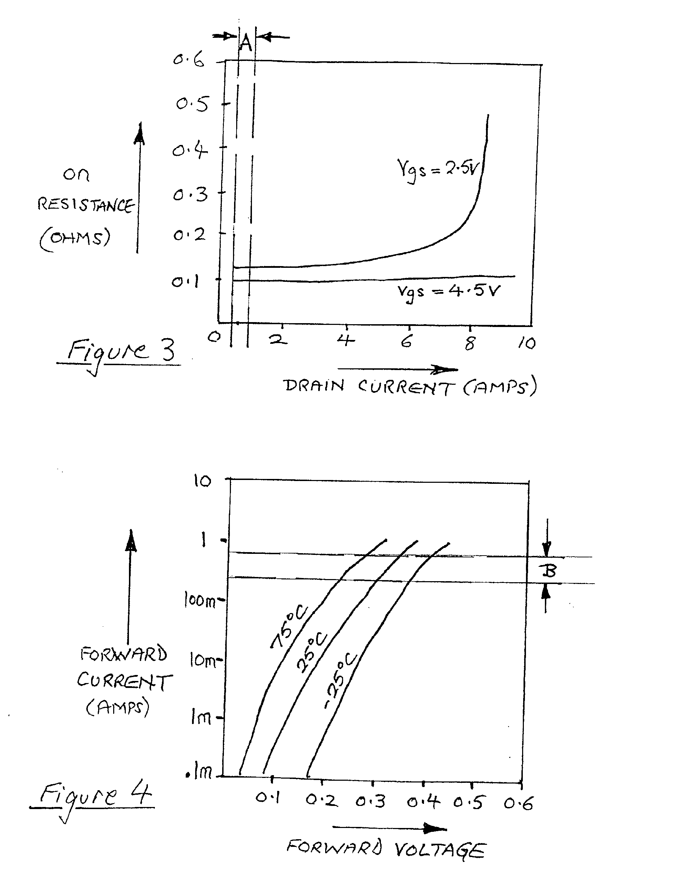

When the FET **23** is switched on, its resistance will vary and will depend upon the amount of current passing through it. A plot of the on-resistance in ohms of FET **23** versus drain current in amperes is shown at figure 3 with an upper curve for gate to source voltage of 2.5 volts and a lower curve for gate to source voltage of 4.5 volts.

It can be observed readily from the plot of figure 3 that for the range of interest for recharging current marked on the plot as **A** (400 to 700 milli-amperes) the variation in the value of the resistance of FET **23** is very small. It has been found that sufficiently accurate and precise measurements of charging current can be obtained by assigning a constant value of resistance to FET **23.** The effects of temperature variations must also be considered. Battery charging is inhibited, however, outside a certain temperature range (0 to 50 degrees celsius) and the variation of resistance with temperature within this range is relatively small.

With reference to figure 4, a plot of the forward characteristics of diode **22** is shown as forward voltage in volts versus forward current in amperes (logarithmic scale) for 75, 25 and -25 degrees celsius. It can be observed from figure 4 that within the range of operation (indicated as **B**) the variation of impedance of diode **22** is small. Therefore the impedance of diode **22** may be assigned a constant value without significant loss of measurement accuracy.

Referring again to figure 2, the potential difference between terminals **21** and **29** is the charging voltage at terminal **21** minus the battery voltage at terminal **29** and is equal to the voltage drops across diode **22** and FET **23**. The current **I** flowing in the charging circuit may be computed from the equation

$$I = \frac{V_{charge} - V_{bat} - V_{offset}}{R_{fet} + R_{diode}} \qquad (1)$$

Where

$V_{charge}$    is the charging voltage at terminal **21**
$V_{bat}$    is the battery voltage measured at terminal **29**
$V_{offset}$    is the voltage offset of diode **22** at a given temperature
$R_{fet}$    is the resistance of FET **23**
$R_{diode}$    is the resistance of diode **22**

Of the terms in equation (1) $V_{charge}$ and $V_{bat}$

are measured values whilst estimated values may be assigned for $V_{diode}$, $R_{fet}$ and $R_{diode}$ V diode comprises a characteristic voltage called the offset and in addition a voltage varying as the product of the current through and impedance of the diode. The offset voltage ($V_{offset}$) varies with temperature and can be assigned a value corresponding to the middle of the temperature range.

More accurate estimates are available for those cases where it is necessary to improve the accuracy of the measurement of charging current. This would apply for example to the charging of a nickel cadmium battery.

The temperature of a battery under charge is altered by the charging process. At the commencement of charging, the temperature of the battery and the temperature of the components in the charging circuit are likely to be the same. The thermistor in the battery pack at start of charge therefore will provide a good estimate of the temperature of the components of the charging circuit. Thereafter during charging of the battery the temperature of the battery and the temperature of the charging circuit will diverge. An additional temperature sensor is included in some devices specifically to provide a measure of the ambient temperature in the region of the main electronic components. Where such a sensor is included the variations of assigned values with temperature can be tracked more closely and assigned values adjusted. An ambient temperature sensor is shown as numeral **5** of figure 1.

The value of the voltage offset may be set more accurately by taking into account the temperature of the diode **22** and computing the value from equation 2.

$$V_{offset} = \frac{V_{hight} - V_{low}}{T_{hight} - T_{low}} * T_{ind} + V_{low} \qquad (2)$$

$V_{high}$    is the diode offset voltage at the top of the temperature range
$V_{low}$    is the diode offset voltage at the bottom of the temperature range
$T_{high}$    is the highest temperature at which charging will proceed (50°)
$T_{low}$    is the lowest temperature at which charging will proceed (0°)
$T_{ind}$    is the measurement from the temperature sensing device **(5)**

Alternatively a sequence of estimated values corresponding to different temperatures across the range may be stored as a look-up table. By this means the estimated values used in a series of computations throughout the charging cycle or at specific intervals may be revised to take account of temperature changes.

An additional measurement point may be made available at terminal **28**. The voltage drop across diode **22** can then be measured between terminals **21** and **28** and the voltage drop across FET **23** can be measured between terminals **28** and **29.** A measure of current ($I_{diode}$) through the charging circuit can then be obtained independently from the voltage drop across diode **22** and the estimated value of resistance of diode **22.** Similarly the voltage drop across FET **23** and the estimated value of resistance of FET **23** may be used to obtain independently a measure of the charging current ($I_{FET}$).

Either one of the computations $I_{diode}$ or $I_{FET}$ can be taken as the level of current where both computations are made available, some average value may be taken, most simply as $I_{charge} = (I_{diode} + I_{FET})/2$

It will generally be found to be more convenient, however, to use the voltage difference between terminals **21** and **29** and the estimated values of voltage offset and resistance of diode **22** and impedance of FET **23** to determine the level of current through the circuit.

## Claims

1. A portable communications terminal including a battery and having a charging circuit for connecting an external charger to said battery, said charging circuit comprising a pass device and a diode connected in series and in which levels of charging current are computed from a difference of potential between said external charger and said battery and stored characteristics of said pass device and diode.

2. A portable communications terminal as in claim 1 in which the stored characteristics are fixed estimates of diode voltage offset and resistance and pass device impedance .

3. A portable communications terminal as in claim 1 in which the stored characteristics are estimated values of diode voltage offset and resistance and pass device impedance set in accordance with measured temperature.

4. A portable communications terminal as in claim 3 in which the estimated values are set in accordance with a measurement of temperature at the start of charging.

5. A portable communications terminal as in claim 4 in which a measurement of temperature at the start of charging is obtained from a sensor adjacent the battery

6. A portable communications terminal as in claims 3 or 4 in which measurement of temperature is obtained from a sensor in the region of the charging circuit.

7. A portable communications terminal as in claim 3 in which successive measurements of temperature are obtained throughout the charging cycle.

8. A portable communications terminal as in claim 7 in which the estimated values are set in accordance with the successive measurements of temperature obtained throughout the charging cycle.

9. A portable communications terminal as in any previous claim in which the estimated values are derived from a look up table.

10. A portable communications terminal as in any previous claim in which the pass device is a FET

11. A portable communications terminal substantially as hereinbefore described in relation to or as illustrated in the accompanying drawings.

CHARGER 7

CHARGING CIRCUIT 6

BATTERY 2

CPU 3

DISPLAY 4

TEMP. SENSOR 5

11

10

8

9

1

Figure 1

Figure 2

Figure 3

ON RESISTANCE (OHMS)

Vgs = 2·5V

Vgs = 4·5V

DRAIN CURRENT (AMPS)

Figure 4

FORWARD CURRENT (AMPS)

75°C

25°C

-25°C

FORWARD VOLTAGE